# EUROPEAN PATENT SPECIFICATION

(11) **EP 0 856 915 B1**
(45) Date of publication and mention of the grant of the patent: **13.02.2002**
(21) Application number: 98200499.6
(22) Date of filing: 25.11.1994
(51) Int. Cl.: H01R 13/436, H01R 12/20

(54) **Header assembly for connection to an electrical pin field**
Kopfteil für die Verbindung eines elektrischen Stiftfeldes
Assemblage pour connecter un réseau de broches électriques

(30) Priority: 13.12.1993 GB 9325421
(43) Date of publication of application: 05.08.1998
(62) Divisional of application: 94308733.8
(73) Proprietor: THE WHITAKER CORPORATION, Wilmington, Delaware 19808 (US)
(72) Inventor: Soes, Lucas, 5248 BB Rosmalen (NL); Broeksteeg,Johannes Marcelus, 5346 WJ Oss (NL)
(74) Representative: Warren, Keith Stanley

(56) References cited:
- EP-A- 0 277 822
- EP-A- 0 378 845
- EP-A- 0 428 259
- EP-A- 0 578 487
- DE-A- 1 640 321

## Description

The present invention relates to a header assembly for connection to an electrical pin field in which pins extend from both sides of a printed circuit board and back-to-back headers can be positioned on opposite sides of the printed circuit board.

It is well known to form a pin field in printed circuit boards. These pins would be electrically connected to circuit traces in a printed circuit board, by way of press fit, for example, by way of compliant pin portions within the printed circuit board through hole. Extending in opposite directions from the compliant pins, are pin portions profiled for mating with complementary terminals in a complementary connector. Housings are positioned over the pins on opposite sides of the printed circuit boards to form a completed connector assembly. A difficulty which has arisen, is the method of retaining the housings to the pin field.

The printed circuit boards of the subject pin fields may have through-holes having a diameter as small as 0.55 mm. Thus, the pin has on one side of the compliant pin portion, an enlarged barb, which is larger than the nominal width of the pin, which is profiled for interference fit within the corresponding housing. However, as the pin must be inserted through the printed circuit board through hole, the side of the pin opposite the entry side of the printed circuit board cannot contain a retaining barb, as it would not fit through the printed circuit board. Therefore, on one side of the printed circuit board, the pin is of a constant width, sometimes as narrow as 0.50 mm. The housings which enclose these pins generally have passageways which are interference fit with the pins.

One of the drawbacks to this approach is that, as the housings are inserted over the pin field, the housings interfere with the pin field and leave some of the plastic on the pins themselves which could lead to an unstable contact, as the plastic is directly on the contact surfaces. Thus, as the mating contact receptacle could have plastic particles between the contact surfaces and the pin itself, an ineffective contact could be made. Secondly, as many housings are made from glass filled housings, the glass particles in the housing could actually skive through the gold plating on the contacts, again leading to an ineffective contact system.

Our prior application EP-A-0 578 487, which is relevant under Art. 54(3) EPC, describes an electrical pin field which alleviates the drawbacks discussed above. It describes an electrical pin field comprising a printed circuit board having a plurality of pins extending between both sides thereof to position pin contact portions on opposite sides of the board, and insulating housings mounted over the pins on both sides of the board, in which at least one of the housings includes a locking plate medially positioned between the board and the housing. The locking plate has a plurality of through-holes for receiving the pins and at least one gripping arm extending towards the housing, adjacent to each through hole. The gripping arms are interference fits with passageways in the housing and are positioned against the pin portions.

Our copending application EP-A-0 657 966, from which the present application is divided, relates to a modification of the pin field described in EP-A-0 578 487 in which the housing having the locking plate and, hence the passageways in the housing, are positioned between the locking plate and the board.

The present invention is directed to the header assembly described in the parent application and consists in a header assembly for connection to an electrical pin field in which pins extend from both sides of a printed circuit board, comprising a housing for mounting over the pins on one side of the board and having an opening in the housing for receiving a complementary plug connector, and a locking plate disposed within the opening in the housing and having a plurality of through-holes for receiving the pins and movable gripping arms extending towards the housing, said locking plate being movable from a preassembled position in the housing and in which the header assembly is slidably received over the pins to a locking position in which each gripping arm is an interference fit in an aperture in the housing so as to be positioned against and grip a pin of the pin field projecting into the aperture.

In order that the present invention may be more readily understood, reference will now be made to the accompanying drawings, in which:-
Figure 1 is a cross-sectional view of the electrical pin field described in our prior application EP-A-0 578 487 and shows a first housing or header mounted to the lower side of a printed circuit board with the spacer member and second housing or header poised for receipt over the pin field;

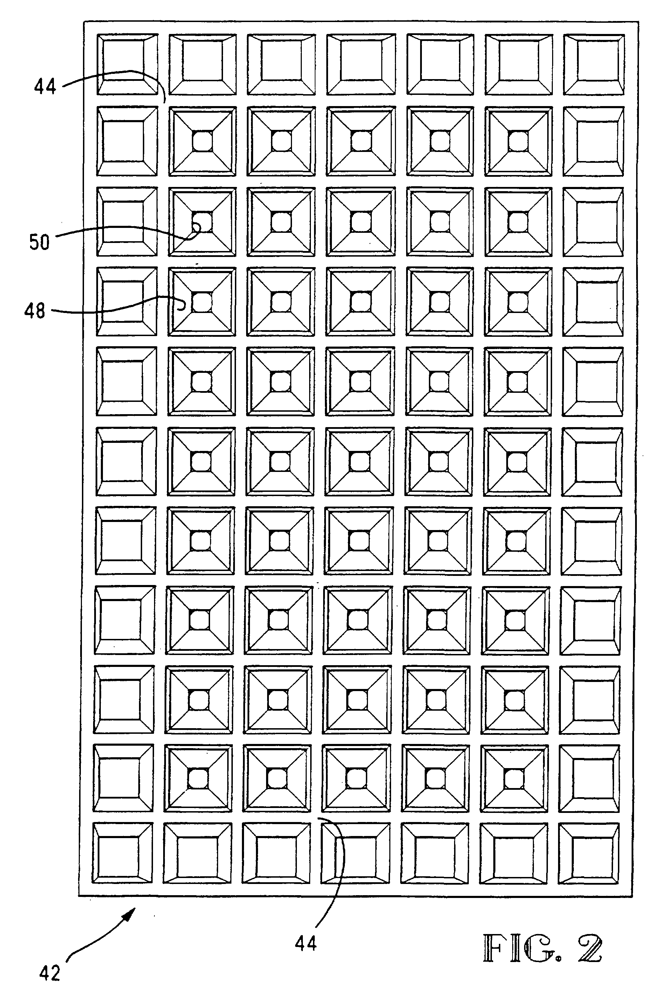

Figure 2 is a top view of the locking plate of Figure 1;
Figure 3 is a side view of the locking plate;
Figure 4 is a lower plan view of the locking plate;
Figure 5 is a cross-sectional view through lines 5-5 Figure 4;
Figure 6 is a plan view of a portion of the electrical pins used for the pin field;
Figure 7 is a view similar to that of Figure 1 showing the initial reception over the header of the spacer plate;

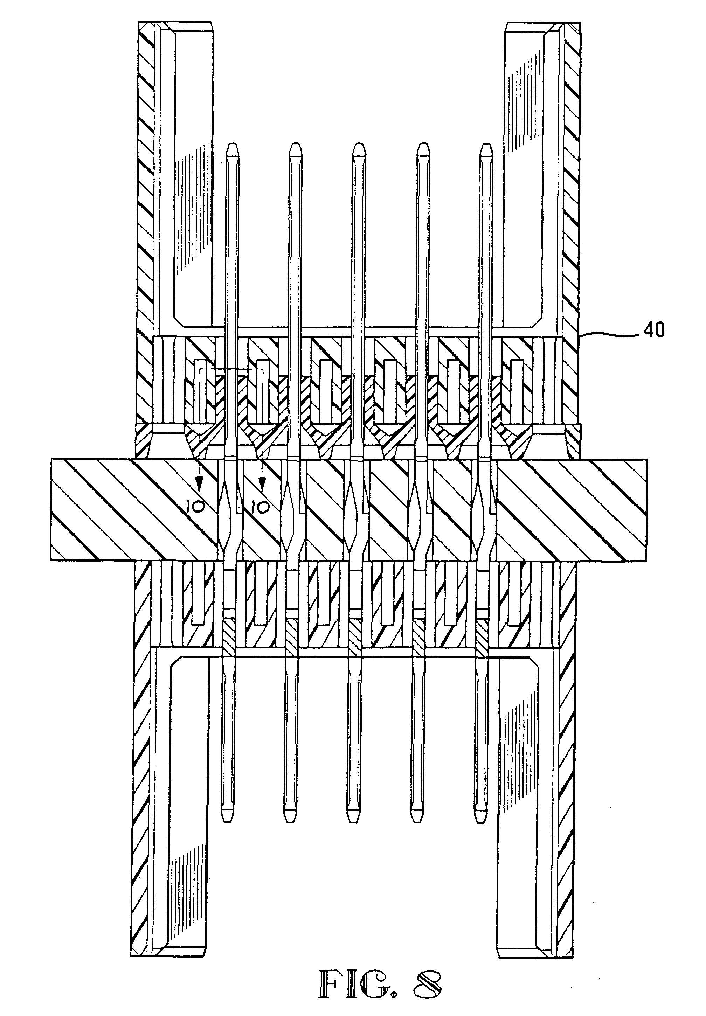

Figure 8 is a view similar to that of Figure 7 showing the fully assembled spacer plate and header of the pin field;
Figure 9 is a cross-sectional view through lines 9-9 of Figure 7;
Figure 10 is a cross-sectional view through lines 10-10 of Figure 8;
Figure 11 shows an upper header embodying the present invention and which can be used with the lower header and pin field of Figure 1;
Figure 12 is a cross-sectional view through lines 12-12 of Figure 11; and
Figure 13 is a side view of the header shown in Figure 11.

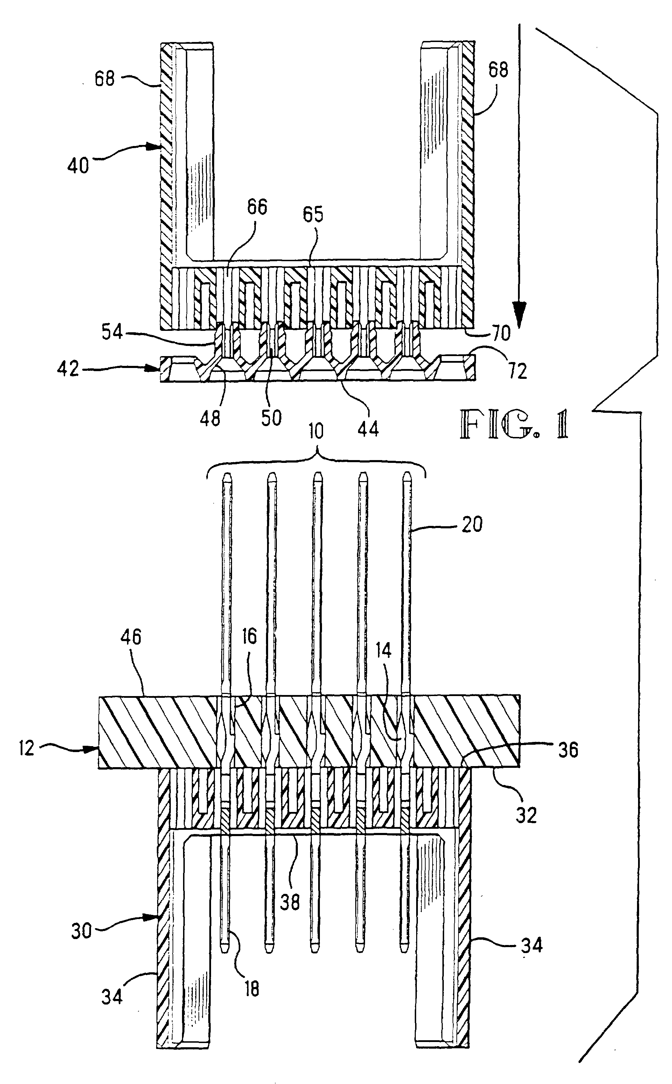

With reference first to Figure 1, the electrical pin field of our prior application comprises a plurality of pins 10 positioned on the printed circuit board 12, the pins being retained in position on the printed circuit board by compliant portions 14 on the pins inserted into through-holes 16 on the printed circuit board. The pins 10 generally include contact portions 18 on one side of the printed circuit board and contact portions 20 on the opposite side, the contact portions 18 and 20 being profiled for receiving complementary plug connectors in electrical engagement.

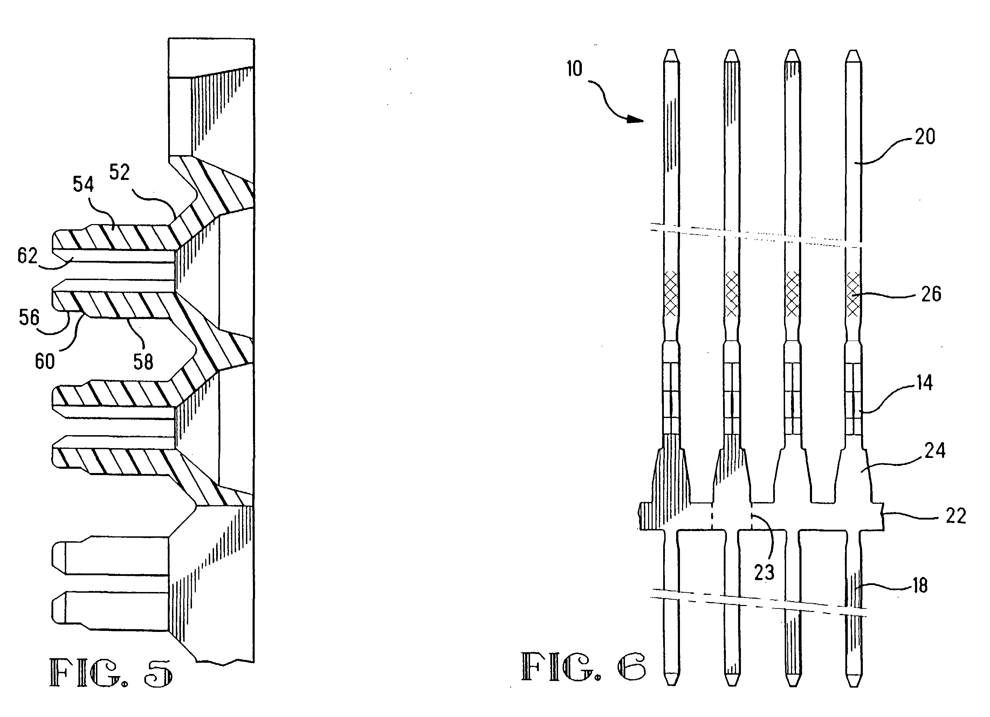

With respect now to Figure 6, the electrical pins 10 are shown as they are formed on a carrier strip such as 22 for reeling, or for assembly purposes with the electrical housings. The pins 10 will be sheared from the carrier strip 22 at phantom lines 23 for end use. The compliant portions are shown generally at 14 with enlarged portions shown at 24 which will be used for retaining the pin terminals within their respective housings, as will be described in greater detail herein. The contact portions 20 are shown above the compliant portion 14 whereas the compliant portions 18 are shown positioned below the compliant portions 14. The surfaces at 26 are roughened to provide a greater frictional surface.

With reference again to Figure 1, a housing member 30, made from an insulating material, is positioned over the contact portions 18 of the pins 10 to form a header assembly on the lower side 32 of the printed circuit board 12. This header assembly could be similar to that shown in EP-A-0 422 785. The housing 30 generally comprises upstanding sidewalls 34 on either side thereof which provides an opening for a complementary plug connector which could either be shielded or unshielded. With reference again to Figure 6, it should be noted that the enlarged portions 24 of the pins 10 are positioned medially of the contact portions 18 and the compliant pin portions 14. The insulating housing 30 is profiled to receive the contact portions 18 from a rear side 36 of the housing 30.

The pins 10 can either be positioned in the printed circuit board 12, and then later receive the housing 30 thereover such that the housing 30 is positioned with the mounting face 36 facing the surface 32 of the printed circuit board and then forced against the printed circuit board. Alternatively, the pins 10 could be forced the housing 30 and the header assembly comprising the housing 30 and the pins 10 could be placed against the lower side 32 of the printed circuit board 30. In either case, it should be appreciated that the enlarged portions 24 of the pins 10 prevent removal of the housing over the pins, the housing 30 being profiled to receive the enlarged portions 24 therein.

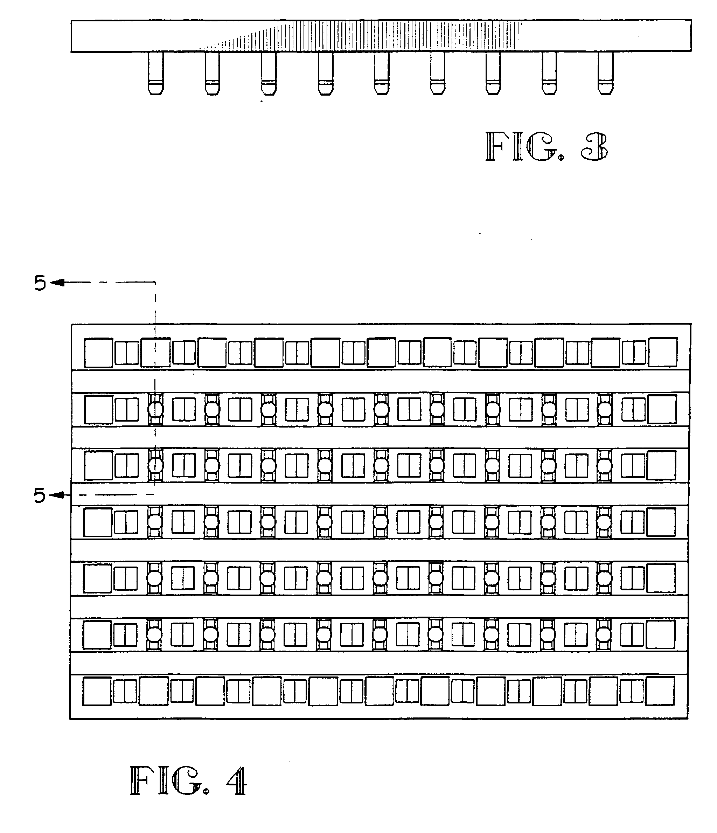

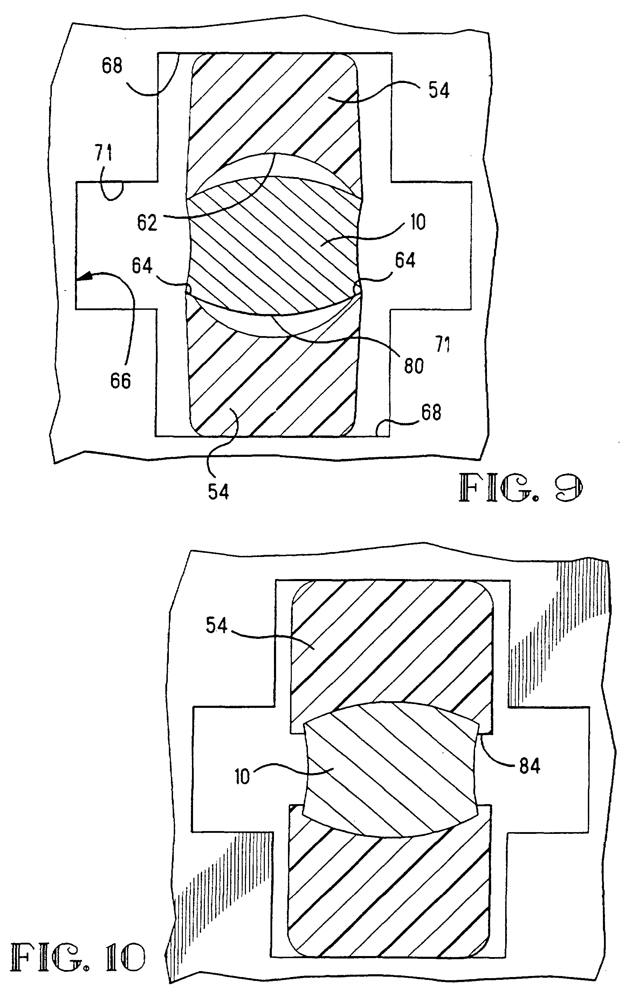

The pins 10 are profiled to be received in a printed circuit board through-hole having a 0.55 mm diameter. Therefore, as the pins must pass through the printed circuit board, with the contact portion 20 leading, this prevents having an enlarged portion similar to 24 on the opposite side of the compliant pin portion 14 for retaining another housing thereto. Hence, this other housing is retained in position by a locking spacer plate or member 42. The locking plate 42 has a lower face at 44 which is profiled for receipt against an upper surface 46 of the printed circuit board 12. It includes a plurality of lead-in openings 48 for easy placement of the locking spacer member 42 over the pin field at 10. Movement of the plate 42 over the pin field, centers each of the pins 10 with a central through hole 50 in the spacer plate 42. As shown best in Figures 3-5, the spacer plate 42 has an opposite surface 52 including gripping or locking arms 54 extending from opposite sides of the opening 50. As shown best in Figure 5, the locking arms 54 include thin portions 56 adjacent to the distal end thereof and thickened portions 58 defined through a transition section 60. Also with reference to Figure 5 and 9, the surface facing the pins 10 has a cylindrical surface 62 forming outer tip surfaces at 64.

With reference again to Figure 1, the housing member 40 is similar in nature to the housing member 30, including a central section at 65 having a plurality of terminal passageways at 66 and sidewalls at 68 for receiving a complementary plug member. The housing member 40 further includes a lower mounting surface 70 which can be placed against a mounting surface 72 of the spacer member 42 when in the final position. As best shown in Figure 9, the housing passageways 66 are cruciform in configuration including end portions 68 which receive the locking arms 54 and side portions 71.

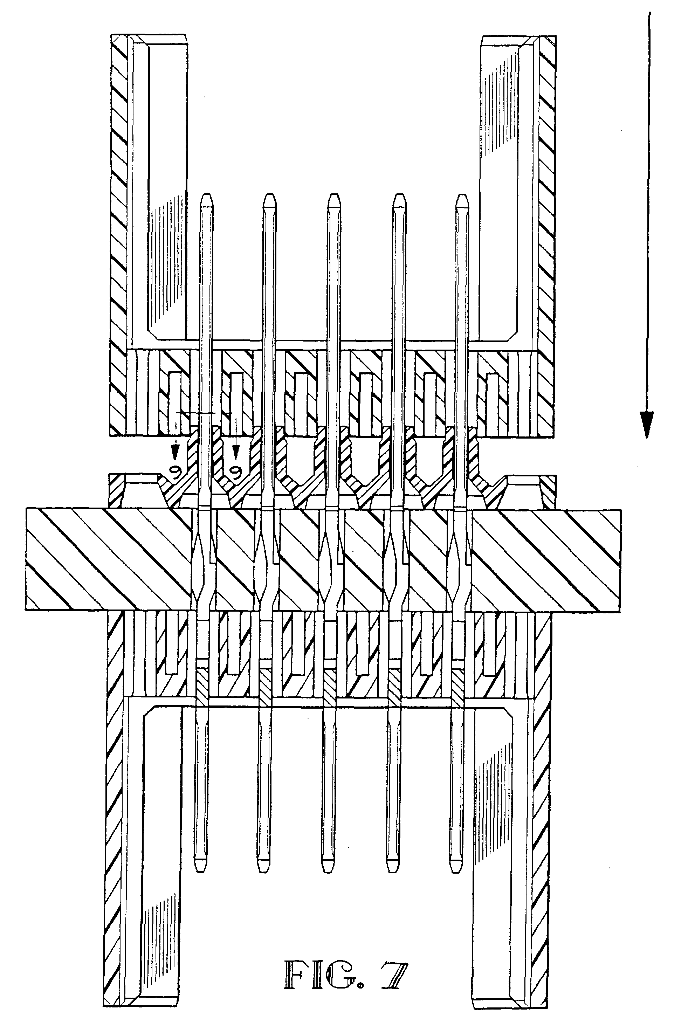

With the pin field 10 and the housing member 30 applied to the printed circuit board 12 as shown in Figure 1 and as described above, the housing member 40 can now be applied to the printed circuit board 12 by way of the locking spacer 42. The spacer member 42 can be attached to the housing member 40 as shown in Figure 1, and applied over the pin field 10 such that the lead in portion 48 are aligned with each of the pins at 10, and the spacer plate 42 can then be lowered until the surface 44 of the spacer member 42 abuts the surface 46 of the printed circuit board. It should be appreciated that, when in the position shown in Figure 7, there is little resistance between the retaining arms 54 and the pins 10, as the narrowed portions 56 of the retaining arms 54 provide little interference with the pins 10. This is best shown in Figure 9 where the outer tips 64 only contact the outer edges of the pin member 10. In the preferred embodiment of the invention, the pin is barrel shaped in cross section, as shown in 10 to cooperate with the contact arms 54.

Further movement of the housing member 40 against the spacer plate 42 causes interference between the contact arms 54 and the pin member 10 by way of the enlarged sections 58 of the locking arms 54. This interference fit causes plastic material to flow around the edges of the pin 1 for example as shown at 84 in Figure 10. In this manner, the locking arms 54 are in gripping position against the roughened portions 26, to thereby retain the housings to the printed circuit board.

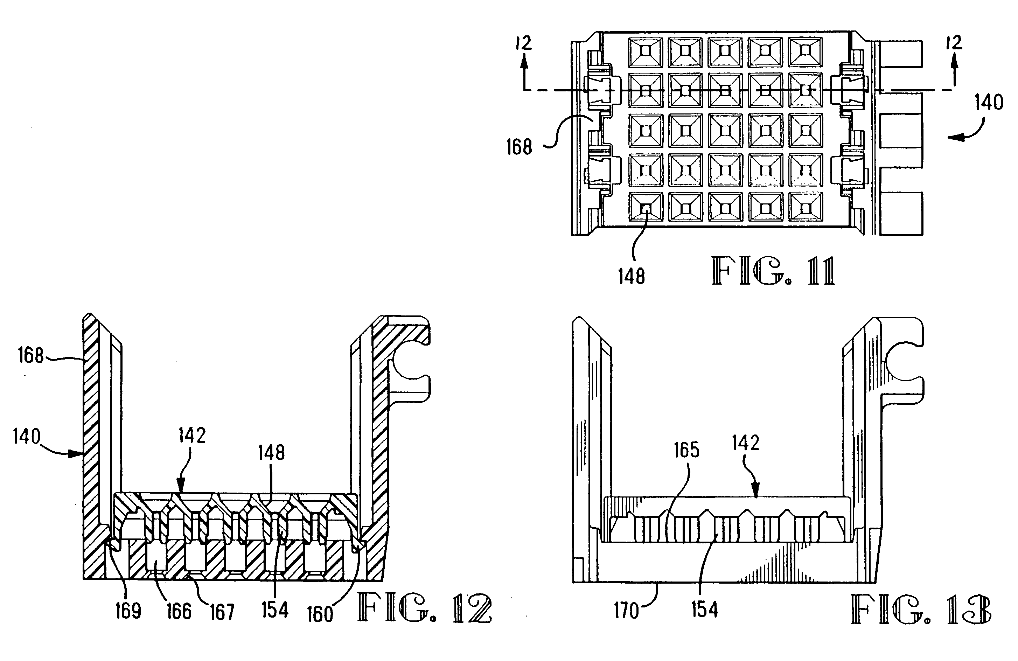

Referring now to Figures 11-13, which illustrate an embodiment of the present invention, the upper housing or header is shown as 140 having a locking plate 142, where the locking plate is positioned against the inside face 165 of the header 140. The locking plate 142 has latches 160 which are locked to corresponding shoulders 169 adjacent to the sidewalls 168. The locking plate 142 has locking arms 154 positioned within apertures 166 of the upper header 140 and operate in identical manner to locking arms 54 with respect to their corresponding apertures 66. The locking plate 142 is shown in its preassembled position in Figures 12 and 13, whereby the upper header 140 together with the locking plate 142 can be slidably received over the pin field 10 as shown in Figure 1, to a position where the lower face 170 abuts the surface 46 of the printed circuit board 12.

The latch arms 160 together with the corresponding locking shoulder 169 retain the locking plate 142 to the upper header 140 during the insertion of the pins 20 between the locking arms 154. The locking plate 142 can thereafter be pushed downwardly such that the locking arms 154 are cammed inwardly as discussed above, and grip the individual pin sections 20. This embodiment has a self-locking geometry whereby if the header 140 is pulled upwardly, the locking arms 154 will be forced further inwardly into the apertures 166 forming a tighter gripping arrangement between the locking arms and the corresponding pins 20.

Advantageously, then the present invention provides a way to attach a housing to a pin field. It is an advantage of the present invention that the housing may be attached without rubbing against the pins during insertion. It is another advantage that the present invention does not require epoxy or mechanical fasteners, such as screws, locking posts, etc. for retaining the housing to the board. The invention is especially advantageous for attaching opposing headers to a board.

## Claims

1. A header assembly for connection to an electrical pin field in which pins (10) extend from both sides of a printed circuit board (12), comprising a housing (140) for mounting over the pins on one side of the board and having an opening in the housing for receiving a complementary plug connector, and a locking plate (142) disposed within the opening in the housing and having a plurality of through-holes for receiving the pins and movable gripping arms (154) extending towards the housing, said locking plate (142) being movable from a preassembled position in the housing and in which the header assembly is slidably received over the pins to a locking position in which each gripping arm (154) is an interference fit in an aperture (166) in the housing so as to be positioned against and grip a pin (10) of the pin field projecting into the aperture.

2. The header assembly of claim 1, wherein each gripping arm has an arcuate surface (62) along its length facing the pin (10).

3. The header assembly of claim 1 or 2, wherein the aperture (166) includes a camming surface for urging the gripping arm (154) into contact with the pin.

4. The header assembly of claim 1, 2 or 3, wherein the locking plate (142) is latched to the housing (140) in the preassembled position, whereby the housing and the locking plate are joined together prior to engagement with the pin field.

5. The header assembly of claim 4,wherein the locking plate (142) includes latches (160) and the housing (140) includes corresponding shoulders (169), the latches being latched to the shoulders to retain the locking plate with the housing.

6. The header assembly of any one of the preceding claims, wherein the holes include a camming surface of self-locking geometry, whereby the camming surface is adapted to tighten the gripping arm (154) upon a pin upon exertion of force upon the housing that would tend to separate the housing from the board.

7. The header assembly of any one of the preceding claims, wherein each gripping arm (154) includes a lead section which interferes with the housing to laterally displace the arm into engagement with the pin.

## Patentansprüche

1. Kopfbaugruppe zur Verbindung mit einem elektrischen Stiftfeld, in dem sich Stifte (10) von beiden Seiten einer Leiterplatte (12) aus erstrecken, mit einem Gehäuse (140) zur Montage über den Stiften auf einer Seite der Platine und mit einer Öffnung in dem Gehäuse zum Aufnehmen eines komplementären Steckverbinders und einer in der Öffnung in dem Gehäuse angeordneten Verriegelungsplatte (142) mit mehreren Durchgangslöchern zum Aufnehmen der Stifte und beweglichen Greifarmen (154), die sich zu dem Gehäuse erstrecken, wobei die Verriegelungsplatte (142) aus einer Vormontageposition in dem Gehäuse, in der die Kopfbaugruppe gleitend über den Stiften aufgenommen wird, in eine Verriegelungsposition bewegt werden kann, in der sich jeder Greifarm (154) in einem Preßsitz in einer Öffnung (166) in dem Gehäuse befindet, um gegen einen Stift (10) des Stiftfelds, der in die Öffnung vorsteht, positioniert zu werden und diesen zu ergreifen.

2. Kopfbaugruppe nach Anspruch 1, wobei jeder Greifarm entlang seiner Länge eine dem Stift (10) zugewandte, bogenförmige Oberfläche (62) aufweist.

3. Kopfbaugruppe nach Anspruch 1 oder 2, wobei die Öffnung (166) eine Steuerfläche zum Drücken des Greifarms (154) in Kontakt mit dem Stift enthält.

4. Kopfbaugruppe nach Anspruch 1, 2 oder 3, wobei die Verriegelungsplatte (142) in der Vormontageposition an dem Gehäuse (140) verrastet ist, wobei das Gehäuse und die Verriegelungsplatte vor der in Eingriffnahme mit dem Stiftfeld miteinander verbunden sind.

5. Kopfbaugruppe nach Anspruch 4, wobei die Verriegelungsplatte (142) Rasten (160) und das Gehäuse (140) entsprechende Schultern (169) enthält, wobei die Rasten an die Schultern gerastet werden, um die Verriegelungsplatte mit dem Gehäuse zu arretieren.

6. Kopfbaugruppe nach einem der vorhergehenden Ansprüche, wobei die Löcher eine Steuerfläche mit selbsthaltender Geometrie enthalten, wodurch die Steuerfläche dafür ausgelegt ist, bei Ausüben von Kraft auf das Gehäuse, die im allgemeinen das Gehäuse von der Platine trennen würde, den Greifarm (154) auf einem Stift festzuziehen.

7. Kopfbaugruppe nach einem der vorhergehenden Ansprüche, wobei jeder Greifarm (154) einen Vorderabschnitt enthält, der mit dem Gehäuse interferiert, um den Arm seitlich in Eingriff mit dem Stift zu verschieben.

## Revendications

1. Ensemble de réceptacles pour connexion à un champ de broches électriques dont les broches (10) débordent des deux côtés d'une carte (12) de circuit imprimé, comprenant un boîtier (140) destiné à être monté sur les broches d'un côté de la carte et présentant une ouverture ménagée dans le boîtier pour recevoir une fiche de connexion complémentaire, et une plaque de verrouillage (142) disposée dans l'ouverture du boîtier et traversée par une pluralité de trous destinés à recevoir les broches, et des bras mobiles de saisie (154) s'étendant vers le boîtier, ladite plaque de verrouillage (142) pouvant être déplacée d'une position prémontée dans le boîtier, et dans lequel l'ensemble de réceptacles est reçu à coulissement sur les broches vers une position de verrouillage dans laquelle chaque bras de saisie (154) est ajusté étroitement dans une ouverture (166) ménagée dans le boîtier de manière à être positionnée contre une broche (10) et à saisir cette broche du champ de broches qui déborde dans l'ouverture.

2. Ensemble de réceptacles selon la revendication 1, dans lequel chaque bras de saisie présente une surface cintrée (62) sur sa longueur tournée vers la broche (10).

3. Ensemble de réceptacles selon la revendication 1 ou 2, dans lequel l'ouverture (166) comprend une surface de came pour repousser le bras de saisie (154) en contact avec la broche.

4. Ensemble de réceptacles selon les revendications 1, 2 ou 3, dans lequel la plaque de verrouillage (142) est verrouillée sur le boîtier (140) en position prémontée, grâce à quoi le boîtier et la plaque de verrouillage sont reliés ensemble avant d'être engagés sur le champ de broches.

5. Ensemble de réceptacles selon la revendication 4, dans lequel la plaque de verrouillage (142) comprend des verrous (160) et le boîtier (140) comprend des épaulements correspondants (169), les verrous étant verrouillés sur les épaulements pour retenir la plaque de verrouillage avec le boîtier.

6. Ensemble de réceptacles selon l'une quelconque des revendications précédentes, dans lequel les trous comprennent une surface de came à géométrie autoblocante, grâce à quoi la surface de came est adaptée pour serrer le bras de saisie (154) sur une broche lorsqu'une force tendant à séparer le boîtier de la carte est exercée sur le boîtier.

7. Ensemble de réceptacles selon l'une quelconque des revendications précédentes, par lequel chaque bras de saisie (154) comprend une section d'attaque qui interfère avec le boîtier pour déplacer latéralement le bras de façon qu'il s'engage sur la broche.
